# EUROPÄISCHE PATENTSCHRIFT

(11) **EP 3 518 263 B1**
(45) Veröffentlichungstag und Bekanntmachung des Hinweises auf die Patenterteilung: **25.11.2020**
(21) Anmeldenummer: 19152680.5
(22) Anmeldetag: 18.01.2019
(51) Int. Cl.: H01H 9/54

(54) **NIEDERSPANNUNGS-SCHUTZSCHALTGERÄT**
LOW VOLTAGE CIRCUIT BREAKER
DISJONCTEUR DE PROTECTION BASSE TENSION

(30) Priorität: 25.01.2018 DE 102018101677
(43) Veröffentlichungstag der Anmeldung: 31.07.2019
(73) Patentinhaber: Eaton Intelligent Power Limited, Dublin 4 (IE)
(72) Erfinder: ASKAN, Kenan, 1090 Wien (AT)
(74) Vertreter: Eaton IP Group EMEA

(56) Entgegenhaltungen:
- WO-A1-2015/028634
- US-A1- 2016 314 928

## Beschreibung

Die Erfindung betrifft ein Niederspannungs-Schutzschaltgerät gemäß dem Oberbegriff des Patentanspruches 1.

Es sind sog. hybride Schaltgeräte bekannt, welche sowohl mechanische Schaltkontakte als auch Halbleiterschalter aufweisen. Derartige Schalter weisen neben den, für die eigentlichen Abschaltfunktionen erforderlichen Komponenten weiters mechanische Trennschalter auf, welche im ausgeschalteten Zustand des Schaltgeräts eine galvanische Trennung bewirken sollen, welche in vielen Ländern bzw. gemäß entsprechender Vorschriften vorgeschrieben sind.

Hybride Schaltgeräte weisen in der Regel zumindest einen Kondensator auf, welcher in der Regel in einem sog. Snubber Schaltkreis angeordnet ist. Nach dem Ausschalten eines solchen hybriden Schaltgeräts wird dieser Kondenstor, wie an sich bekannt, über einen Widerstand entladen, wobei die gespeicherte Energie bzw. Ladung in Wärme umgewandelt wird.

Im Zuge eines Einschaltvorganges eines derartigen Schaltgeräts werden zu aller erst die mechanischen Trennschalter, welche der galvanischen Trennung dienen, geschlossen. Beim ersten elektrisch leitenden Kontakt der Schaltkontakte dieser Trennschalter beginnt der Kondensator in an sich bekannter Weise damit sich aufzuladen und zieht entsprechend einen Ladestrom. Allerdings kommt es beim Schließen der Schaltkontakte der Trennschalter zu einem Prellen der Schaltkontakte, und daher zu aufeinander folgenden kurzzeitigen Unterbrechungen des elektrischen Kontakts. Da jedoch bereits Strom über diese Schaltkontakte gezogen wird, verursacht das Prellen der Schaltkontakte eine Abfolge von Lichtbögen und einen entsprechenden Kontaktabbrand. Dies wird dadurch verstärkt, dass ein entladener Kondensator beim Laden anfangs den höchsten Strom zieht. Dadurch kommt es zu einem Verschleiß der Kontakte der Trennschalter. Dies hat einen erhöhten Widerstand des Schaltgerätes zur Folge. Da die Trennschalter im Normalbetrieb des Schaltgeräts ständig stromdurchflossen sind, führt die Abnützung der Trennkontakte zu einer Vergrößerung der Eigenerwärmung des Schaltgeräts. Da die Lebensdauer von Halbleiterbauteilen stark abhängig von der Umgebungstemperatur ist, kann das besagte Kontaktprellen die Lebensdauer des Schaltgeräts verringern. Ein Ausfall der Halbleiterschaltelemente eines hybriden Schaltgeräts kann ernsthafte Folgen haben.

Zwar besteht bei Wechselstromanwendungen die Möglichkeit den Effekt des Prellens dadurch abzumildern, dass das Schließen der Trennschalter um einen Nulldurchgang der Netzspannung herum erfolgt, um derart den Ladestrom des Kondensators während des Prellens zu verringern. Dadurch können die nachteiligen Folgen zwar verringert jedoch nicht beseitigt werden. Zudem wird das Schalten bzw. Absichern von Gleichstromnetzen immer wichtiger bzw. verbreiteter. Da es bei Gleichstrom keinen Nulldurchgang gibt, gibt es bei Gleichstromanwendungen keine Möglichkeit durch Abstimmen des Schaltzeitpunkts die Lichtbögen zu verringern.

Aufgabe der Erfindung ist es daher ein Niederspannungs-Schutzschaltgerät der eingangs genannten Art anzugeben, mit welchem die genannten Nachteile vermieden werden können, welcher eine geringe Eigenerwärmung und eine hohe Lebensdauer aufweist.

Erfindungsgemäß wird dies durch die Merkmale des Patentanspruches 1 erreicht.

Dadurch können die Trennkontakte lichtbogenfrei geschlossen werden. Dadurch kann erreicht werden, dass auch ein wiederholtes Schalten des Niederspannungs-Schutzschaltgeräts nicht zu einer Alterung der Schaltkontakte aufgrund von Kontaktabbrand führt. Dadurch kann verhindert werden, dass die Eigenerwärmung des Niederspannungs-Schutzschaltgeräts über die Zeit steigt. Dadurch kann die Lebensdauer des Niederspannungs-Schutzschaltgeräts vergrößert werden.

Dadurch kann weiters, bei entsprechender Dimensionierung der einzelnen Komponenten auf einen Varistor verzichtet werden. Die elektrische Energie, welche etwa in den unterschiedlichen Bauteilen und den Streuinduktivitäten gespeichert ist, kann im Zuge eines Abschaltvorganges dazu verwendet werden den ersten Kondensator aufzuladen. Diese Energie wird ansonsten durch einen Varistor in Wärme umgewandelt, welche aus dem Niederspannungs-Schutzschaltgerät abgeführt werden muss.

Die Unteransprüche betreffen weitere vorteilhafte Ausgestaltungen der Erfindung.

Ausdrücklich wird hiermit auf den Wortlaut der Patentansprüche Bezug genommen, wodurch die Ansprüche an dieser Stelle durch Bezugnahme in die Beschreibung eingefügt sind und als wörtlich wiedergegeben gelten.

Die Erfindung wird unter Bezugnahme auf die beigeschlossene Zeichnung, in welcher lediglich eine bevorzugte Ausführungsformen beispielhaft dargestellt ist, näher beschrieben. Dabei zeigt:

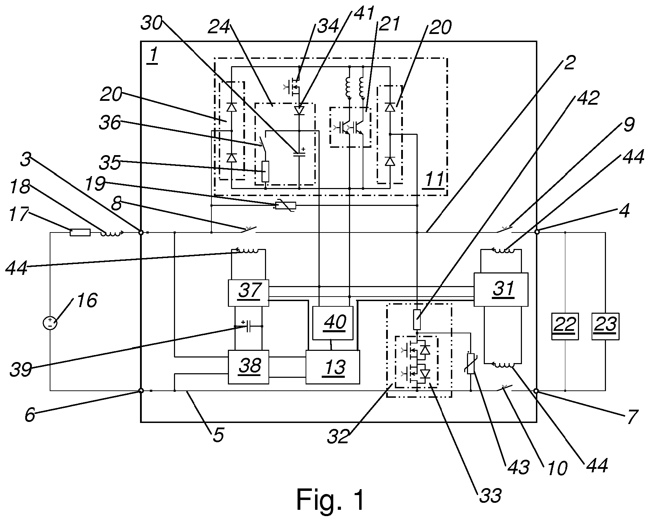

Fig. 1 eine schematische Darstellung einer bevorzugten Ausführungsform eines gegenständlichen Niederspannungs-Schutzschaltgeräts.

Die Fig. 1 zeigt ein Niederspannungs-Schutzschaltgerät 1 mit zumindest einer Außenleiterstrecke 2 von einem Außenleiterversorgungsanschluss 3 des Niederspannungs-Schutzschaltgeräts 1 zu einem Außenleiterlastanschluss 4 des Niederspannungs-Schutzschaltgeräts 1, und einer Neutralleiterstrecke 5 von einem Neutralleiteranschluss 6 des Niederspannungs-Schutzschaltgeräts 1 zu einem Neutralleiterlastanschluss 7 des Niederspannungs-Schutzschaltgeräts 1, wobei in der Außenleiterstrecke 2 ein mechanischer Bypassschalter 8 und ein erster mechanischer Trennschalter 9 seriell angeordnet sind, wobei in der Neutralleiterstrecke 5 ein zweiter mechanischer Trennschalter 10 angeordnet ist, wobei eine erste Halbleiterschaltungsanordnung 11 des Niederspannungs-Schutzschaltgeräts 1 parallel zum Bypassschalter 8 geschaltet ist, wobei eine elektronische Steuereinheit 13 des Niederspannungs-Schutzschaltgeräts 1 dazu ausgebildet ist, den Bypassschalter 8, den ersten mechanischen Trennschalter 9, den zweiten mechanischen Trennschalter 10 und die erste Halbleiterschaltungsanordnung 11 vorgebbar zu betätigen, wobei die erste Halbleiterschaltungsanordnung 11 einen Snubber 24, umfassend einen ersten Kondensator 30, aufweist, wobei der erste Kondensator 30 als Energiespeicher für eine Betätigung des ersten Trennschalters 9 und des zweiten Trennschalters 10 ausgebildet ist, und wobei der erste Kondensator 30 schaltungstechnisch mit einer ersten Betätigungsanordnung 31 des ersten Trennschalters 9 und des zweiten Trennschalters 10 verbunden ist.

Dadurch können die Trennschalter 9, 10 lichtbogenfrei geschlossen werden. Dadurch kann erreicht werden, dass auch ein wiederholtes Schalten des Niederspannungs-Schutzschaltgeräts 1 nicht zu einer Alterung der Schaltkontakte aufgrund von Kontaktabbrand führt. Dadurch kann verhindert werden, dass die Eigenerwärmung des Niederspannungs-Schutzschaltgeräts 1 über die Zeit steigt. Dadurch kann die Lebensdauer des Niederspannungs-Schutzschaltgeräts 1 vergrößert werden.

Dadurch kann weiters, bei entsprechender Dimensionierung der einzelnen Komponenten auf einen Varistor 19 verzichtet werden. Die elektrische Energie, welche etwa in den unterschiedlichen Bauteilen und den Streuinduktivitäten gespeichert ist, kann im Zuge eines Abschaltvorganges dazu verwendet werden den ersten Kondensator 30 aufzuladen. Diese Energie wird ansonsten durch einen Varistor 19 in Wärme umgewandelt, welche aus dem Niederspannungs-Schutzschaltgerät 1 abgeführt werden muss.

Bei dem gegenständlichen Niederspannungs-Schutzschaltgerät 1 wie auch dem Schutzschaltgerät gemäß der WO 2015/028634 A1 handelt es sich um Niederspannungs-Schutzschaltgeräte. Als Niederspannung wird wie an sich üblich der Bereich bis 1000V Wechselspannung bzw. 1500V Gleichspannung bezeichnet.

Fig. 1 zeigt ein Niederspannungs-Schutzschaltgerät 1 gemäß einer bevorzugten Ausführung. Dieses weist eine Außenleiterstrecke 2 sowie eine Neutralleiterstrecke 5 auf. Die Außenleiterstrecke 2 verläuft durch das Schutzschaltgerät 1 von einem Außenleiterversorgungsanschluss 3 zu einem Außenleiterlastanschluss 4. Die Neutralleiterstrecke 5 verläuft durch das Schutzschaltgerät 1 von einem Neutralleiteranschluss 6 zu einem Neutralleiterlastanschluss 7. Die betreffenden Anschlüsse 3, 4, 6, 7 sind jeweils bevorzugt als Schraubanschlussklemmen bzw. Steckanschlussklemmen ausgebildet, und in dem Schutzschaltgerät 1 von außen zugänglich angeordnet.

Der Schaltungsaufbau mit den einzelnen Komponenten und den entsprechenden schaltungstechnischen Verbindungen gemäß Fig. 1 ist Teil der Beschreibung.

Das Schutzschaltgerät 1 weist bevorzugt ein Isolierstoffgehäuse auf.

In der Außenleiterstrecke 2 ist ein mechanischer Bypassschalter 8 angeordnet. In der Außenleiterstrecke 2 ist ein erster mechanischer Trennschalter 9 seriell zum Bypassschalter 8 angeordnet. In der Neutralleiterstrecke 5 ist ein zweiter mechanischer Trennschalter 10 angeordnet. Parallel zum Bypassschalter 8 ist eine Halbleiterschaltungsanordnung 11 geschaltet.

Das Niederspannungs-Schutzschaltgerät 1 weist weiters bevorzugt eine, nicht dargestellte Strommessanordnung auf, welche in der Außenleiterstrecke 2 angeordnet ist, und welche bevorzugt umfassend einem Shunt-Widerstand ausgebildet ist. Die Strommessanordnung ist mit einer elektronischen Steuereinheit 13 des Niederspannungs-Schutzschaltgeräts 1 verbunden, welche bevorzugt umfassend einen Mikrocontroller bzw. Mikroprozessor ausgebildet ist.

Die elektronische Steuereinheit 13 ist dazu ausgebildet, den Bypassschalter 8 und die erste Halbleiterschaltungsanordnung 11, sowie den ersten mechanischen Trennschalter 9 und den zweiten mechanischen Trennschalter 10 anzusteuern, daher diese vorgebbar zu betätigen bzw. zu schalten. Hiezu ist die elektronische Steuereinheit 13 mit der ersten Halbleiterschaltungsanordnung 11, sowie weiters mit den, insbesondere elektromagnetischen, Betätigungselementen des ersten mechanischen Trennschalters 9 und des zweiten mechanischen Trennschalters 10 bevorzugt schaltungstechnisch verbunden. In Fig. 1 sind zum ersten und zweiten Trennschalter 9, 10 weiters jeweils eine Relaisspule 44 eingezeichnet, welche mit einer ersten Betätigungsanordnung 31 verbunden sind. Die erste Betätigungsanordnung 31 weist dabei die, zur Ansteuerung der Relaisspulen 44 gegebenenfalls erforderliche Treiberschaltung auf.

Entsprechend ist die Steuereinheit 13 auch mit einer zweiten Betätigungseinrichtung 37 verbunden, welche die entsprechende Treiberschaltung für den Bypassschalter 8 aufweist, und mit einer, dem Bypassschalter 8 zugeordneten weiteren Relaisspule 44 verbunden ist. Als Energiequelle zum Schalten des Bypassschalters 8 dient der zweite Kondensator 39, welcher mit dem Netzteil 38 verbunden ist. Die entsprechenden Verbindungen ausgehend von der elektronischen Steuereinheit 13 sind in Fig. 1 dargestellt.

Die erste Halbleiterschaltungsanordnung 11 weist bevorzugt eine Gleichrichterschaltung 20, welche bevorzugt als Vollbrücke ausgebildet ist, sowie, bei der gegenständlichen Ausführungsform zwei Leistungshalbleiter 21, welche gegenständlich als IGBT ausgebildet sind, als eigentliche Schalt- bzw. Regelelemente auf. Dabei kann auch lediglich ein einzelner Leistungshalbleiter 21 vorgesehen sein.

In Fig. 1 ist neben dem eigentlichen Niederspannungs-Schutzschaltgerät 1 weiters die elektrische Umgebung angedeutet. Dabei ist das Versorgungsnetz durch die AC/DC-Netzspannungsquelle 16, den Netzinnenwiderstand 17 und die Netzinduktivität 18 dargestellt. Weiters ist eine elektrische Last 23, sowie ein elektrischer Fehler 22 in Form eines Kurzschlusses dargestellt.

Bei einem Niederspannungs-Schaltgerät 1, wie in Fig. 1 gezeigt, ist vorgesehen, dass ein Abschaltvorgang von dem Bypassschalter 8 und der ersten Halbleiterschaltungsanordnung 11 durchgeführt wird, und die ersten und zweiten Trennschalter 9, 10 lediglich dazu dienen, nach erfolgter Abschaltung eine galvanische Trennung des Lastkreises sicherzustellen.

Die erste Halbleiterschaltungsanordnung 11 weist weiters einen Snubber 24 auf. Snubber 24 ist dabei eine in der Elektrotechnik gebräuchliche Bezeichnung für eine Dämpfungseinrichtung. Der Snubber 24 weist wenigstens einen ersten Kondensator 30 auf. Es ist vorgesehen, dass der erste Kondensator 30 als Energiespeicher für die Betätigung des ersten Trennschalters 9 und des zweiten Trennschalters 10 verwendet wird. Dazu ist der erste Kondensator 30 schaltungstechnisch mit der ersten Betätigungsanordnung 31 des ersten Trennschalters 9 und des zweiten Trennschalters 10 verbunden. Selbstverständlich kann auch eine Parallelschaltung mehrerer diskreter Kondensatoren den ersten Kondensator 30 bilden.

Bei ausreichend großer Dimensionierung des ersten Kondensators 30 kann auf den ersten spannungsabhängigen Widerstand 19 verzichtet werden. Dies stellt einen besonderen Vorteil dar, da dadurch nicht nur auf einen Bauteil verzichtet werden kann, welcher viel Bauraum beansprucht, sondern welcher auch über die Einsatzzeit des Niederspannungs-Schutzschaltgeräts 1 seine Eigenschaften in ungünstiger Weise ändert.

Der erste Kondensator 30 kann durch die Energie aufgeladen werden, welche im Zuge eines Abschaltvorganges in der Schaltung vorhanden ist. Um jedoch für alle Eventualitäten eine ausreichende Ladung des ersten Kondensators 30 zu gewährleisten, ist bevorzugt vorgesehen, dass das Niederspannungs-Schutzschaltgerät 1 eine Ladeschaltung 32 zum vorgebbaren Aufladen des ersten Kondensators 30 aufweist.

Die Ladeschaltung 32 weist bevorzugt eine, von der Steuereinheit 13 angesteuerte, zweite Halbleiterschaltungsanordnung 33 auf, welche besonders bevorzugt als bidirektionaler vier Quadranten Schalter ausgebildet ist.

Die Ladeschaltung 32 verbindet im durchgeschalteten Zustand der zweiten Halbleiterschaltungsanordnung 33 sowie bei geöffnetem Bypassschalter 8 die erste Halbleiterschaltungsanordnung 11 mit der Außenleiterstrecke 2 sowie der Neutralleiterstrecke 5, wodurch der erste Kondensator 30 geladen wird.

Um ein Entladen des ersten Kondensators 30 zu verhindern bzw. genau steuern zu können, ist bevorzugt vorgesehen, dass in der ersten Halbleiterschaltungsanordnung 11, seriell zum Snubber 24 eine dritte Halbleiterschaltungsanordnung 34 angeordnet ist. Gemäß der bevorzugten Ausführungsform umfasst die dritte Halbleiterschaltungsanordnung 34 einen Transistor, insbesondere einen MOSFET, zu dem seriell eine Sperrdiode 41 geschaltet ist. Die dritte Halbleiterschaltungsanordnung 34 ist ansteuerungstechnisch mit der elektronischen Steuereinheit 13 verbunden.

Im Normalfall soll der erste Kondensator 30 geladen sein, und es soll zudem verhindert werden, dass sich dieser ungeplant entlädt. An weiterer Stelle werden bevorzugte Betriebsweisen beschrieben. Um jedoch gezielt einen stromlosen Zustand des Niederspannungs-Schutzschaltgeräts 1 hervorrufen zu können, wie dies etwa für Wartungs- oder Reparaturarbeiten erforderlich ist, ist gemäß einer weiteren bevorzugten Ausführungsform vorgesehen, dass der Snubber 24 einen ersten Widerstand 35 aufweist, welcher parallel zum ersten Kondensator 30 angeordnet bzw. geschaltet ist, und dass ein Entladeschalter 36 seriell zum ersten Widerstand 35 sowie parallel zum ersten Kondensator 30 angeordnet ist. Durch schließen des Entladeschalters 36 kann der erste Kondensator 30 entladen werden, und so die Gefahr der Beschädigung des Niederspannungs-Schutzschaltgeräts 1 oder einer Verletzung eines Technikers verhindert werden.

Nachfolgend wird der bevorzugte Vorgang eines Einschaltens des Niederspannungs-Schutzschaltgeräts 1 beschrieben. Dazu ist bevorzugt vorgesehen, dass die, entsprechend ausgebildete elektronische Steuereinheit 13, zum Laden des ersten Kondensators 30, erst die zweite Halbleiterschaltungsanordnung 33 einschaltet, und nachfolgend die dritte Halbleiterschaltungsanordnung 34 einschaltet. Dadurch beginnt ein Strom zu fließen, welcher mittels der Begrenzungswiderstandes 42 begrenzt wird. Auf den Begrenzungswiderstand 42 kann auch verzichtet werden, wenn die zweite Halbleiterschaltungsanordnung 33 und die dritte Halbleiterschaltungsanordnung 34 in Sättigung betrieben werden. Danach wird abgewartet bis der erste Kondensator 30 eine vorgebbare Ladung aufweist bzw. erreicht hat. Die Ladezustandsüberwachungseinheit 40 misst hiezu die Spannung am ersten Kondensator 30. Dabei kann der erste Kondensator 30 - wie an sich bekannt - auf die maximal anliegende Spannung, daher die Quellenspannung geladen werden.

Nach Erreichen der vorgebbaren Ladung des ersten Kondensators 30 wird zuerst die zweite Halbleiterschaltungsanordnung 33 abgeschaltet und nachfolgend die dritte Halbleiterschaltungsanordnung 34 abgeschaltet. Die Sperrdiode 41 verhindert die ungewollte Entladung des ersten Kondensators 30.

Nachfolgend wird zuerst der zweite Trennschalter 10 geschlossen und nachfolgend wird der erste Trennschalter 9 geschlossen. Dabei kommt es zu dem einleitend beschriebenen Effekt des Kontaktprellens, welches jedoch stromlos und daher ohne Lichtbögen erfolgt, da die Sperrdiode 41 und die dritte Halbleiterschaltungsanordnung 34 die Spannung des ersten Kondensators 30 blockieren.

Nach Erreichen eines stabilen Zustandes des ersten Trennschalters 9 und des zweiten Trennschalters 10 wird die erste Halbleiterschaltungsanordnung 11 eingeschaltet. Gemäß einer einfachen Ausführungsform wird hiezu eine vorgebbare, und aus Versuchen ermittelte, Zeitspanne nach Abgabe des entsprechenden Signals zum Schließen des ersten und zweiten Trennschalters 9, 10 gewartet. Die entsprechende Energie zum Einschalten der ersten Halbleiterschaltungsanordnung 11 wird seitens des Netzteiles 38 geliefert. Wie an sich bekannt, kann danach Strom zu einer gegebenenfalls vorhandenen Last fließen.

Sofern zu diesem Zeitpunkt kein Überstrom oder Kurzschluss detektiert wird, wird nachfolgend der Bypassschalter 8 geschlossen und die erste Halbleiterschaltungsanordnung 11 ausgeschaltet. Bei Wechselstrom erfolgt das Schließen des Bypassschalters 8 in an sich bekannter Weise am Nulldurchgang der Spannung. Die entsprechende Energie zum Schließen des Bypassschalters 8 wird vom ersten Kondensator 30 geliefert.

Die elektronische Steuereinheit 13 ist weiters bevorzugt dazu ausgebildet, bei eingeschaltetem Niederspannungs-Schutzschaltgerät 1, durch vorgebbare Betätigung der zweiten Halbleiterschaltungsanordnung 33 und der dritten Halbleiterschaltungsanordnung 34 den ersten Kondensator 30 vorgebbar zu laden. Dadurch kann unabhängig von sonstigen betriebsgemäßen Einflüssen eine ausreichende Ladung des ersten Kondensators 30 sichergestellt werden. Dadurch kann auch ein Abschaltvorgang durchgeführt werden, wenn die Versorgung nur sehr wenig Strom liefert.

Das Ausschalten eines gegenständlichen Niederspannungs-Schutzschaltgeräts1 erfolgt im Wesentlichen bzw. bis auf den nachfolgend beschriebenen Unterschied in an sich bekannter Weise, wie dies auch in der WO 2015/028634 A1 beschrieben ist. Im Gegensatz zu dieser wird jedoch die Ladung des ersten Kondensators 30 nicht über Widerstände in Wärme umgewandelt, sondern dazu verwendet den ersten mechanischen Trennschalter 9 und den zweiten mechanischen Trennschalter 10 zu öffnen, sobald der Strom im Wesentlichen Null ist. Bei ausreichend großer Dimensionierung des ersten Kondensators 30 kann auf den Varistor 19 verzichtet werden. Dadurch können auch die ansonsten auftretenden Alterungsprobleme von Varistoren vermieden werden.

## Patentansprüche

1. Niederspannungs-Schutzschaltgerät (1) mit zumindest einer Außenleiterstrecke (2) von einem Außenleiterversorgungsanschluss (3) des Niederspannungs-Schutzschaltgeräts (1) zu einem Außenleiterlastanschluss (4) des Niederspannungs-Schutzschaltgeräts (1), und einer Neutralleiterstrecke (5) von einem Neutralleiteranschluss (6) des Niederspannungs-Schutzschaltgeräts (1) zu einem Neutralleiterlastanschluss (7) des Niederspannungs-Schutzschaltgeräts (1), wobei in der Außenleiterstrecke (2) ein mechanischer Bypassschalter (8) und ein erster mechanischer Trennschalter (9) seriell angeordnet sind, wobei in der Neutralleiterstrecke (5) ein zweiter mechanischer Trennschalter (10) angeordnet ist, wobei eine erste Halbleiterschaltungsanordnung (11) des Niederspannungs-Schutzschaltgeräts (1) parallel zum Bypassschalter (8) geschaltet ist, wobei eine elektronische Steuereinheit (13) des Niederspannungs-Schutzschaltgeräts (1) dazu ausgebildet ist, den Bypassschalter (8), den ersten mechanischen Trennschalter (9), den zweiten mechanischen Trennschalter (10) und die erste Halbleiterschaltungsanordnung (11) vorgebbar zu betätigen, wobei die erste Halbleiterschaltungsanordnung (11) einen Snubber (24), umfassend einen ersten Kondensator (30), aufweist, **dadurch gekennzeichnet, dass** der erste Kondensator (30) als Energiespeicher für eine Betätigung des ersten Trennschalters (9) und des zweiten Trennschalters (10) ausgebildet ist, und dass der erste Kondensator (30) schaltungstechnisch mit einer ersten Betätigungsanordnung (31) des ersten Trennschalters (9) und des zweiten Trennschalters (10) verbunden ist.

2. Niederspannungs-Schutzschaltgerät (1) nach Anspruch 1, **dadurch gekennzeichnet, dass** das Niederspannungs-Schutzschaltgerät (1) eine Ladeschaltung (32) zum vorgebbaren Aufladen des ersten Kondensators (30) aufweist.

3. Niederspannungs-Schutzschaltgerät (1) nach Anspruch 2, **dadurch gekennzeichnet, dass** die Ladeschaltung (32) eine, von der Steuereinheit (13) angesteuerte, zweite Halbleiterschaltungsanordnung (33) aufweist.

4. Niederspannungs-Schutzschaltgerät (1) nach Anspruch 3, **dadurch gekennzeichnet, dass** die zweite Halbleiterschaltungsanordnung (33) als bidirektionaler vier Quadranten Schalter ausgebildet ist.

5. Niederspannungs-Schutzschaltgerät (1) nach Anspruch 3 oder 4, **dadurch gekennzeichnet, dass** die Ladeschaltung (32) im durchgeschalteten Zustand der zweiten Halbleiterschaltungsanordnung (33) sowie bei geöffnetem Bypassschalter (8) die erste Halbleiterschaltungsanordnung (11) mit der Außenleiterstrecke (2) sowie der Neutralleiterstrecke (5) verbindet.

6. Niederspannungs-Schutzschaltgerät (1) nach einem der Ansprüche 1 bis 5, **dadurch gekennzeichnet, dass** in der ersten Halbleiterschaltungsanordnung (11), seriell zum Snubber (24) eine dritte Halbleiterschaltungsanordnung (34) angeordnet ist.

7. Niederspannungs-Schutzschaltgerät (1) nach einem der Ansprüche 1 bis 6, **dadurch gekennzeichnet, dass** der Snubber (24) einen ersten Widerstand (35) aufweist, welcher parallel zum ersten Kondensator (30) angeordnet ist, und dass ein Entladeschalter (36) seriell zum ersten Widerstand (35) sowie parallel zum ersten Kondensator (30) angeordnet ist.

8. Niederspannungs-Schutzschaltgerät (1) nach Anspruch 6 oder 7, **dadurch gekennzeichnet, dass** die elektronische Steuereinheit (13) dazu ausgebildet ist, beim Einschalten des Niederspannungs-Schutzschaltgeräts (1) erst die zweite Halbleiterschaltungsanordnung (33) einzuschalten, nachfolgend die dritte Halbleiterschaltungsanordnung (34) einzuschalten, nachfolgend nach Erreichen einer vorgebbaren Ladung des ersten Kondensators (30), erst den zweiten Trennschalter (10) und nachfolgend den ersten Trennschalter (9) zu schließen, nachfolgend nach Erreichen eines stabilen Zustandes des ersten Trennschalters (9) und des zweiten Trennschalters (10) die erste Halbleiterschaltungsanordnung (11) einzuschalten, und nachfolgend den Bypassschalter (8) zu schließen und die erste Halbleiterschaltungsanordnung (11) auszuschalten.

9. Niederspannungs-Schutzschaltgerät (1) nach einem der Ansprüche 6 bis 8, **dadurch gekennzeichnet, dass** die elektronische Steuereinheit (13) dazu ausgebildet ist bei eingeschaltetem Niederspannungs-Schutzschaltgerät (1), durch vorgebbare Betätigung der zweiten Halbleiterschaltungsanordnung (33) und der dritten Halbleiterschaltungsanordnung (34) den ersten Kondensator (30) vorgebbar zu laden.

## Claims

1. Low-voltage circuit breaker (1) having at least one outer conductor path (2) extending from an outer conductor supply terminal (3) of the low-voltage circuit breaker (1) to an outer conductor load terminal (4) of the low-voltage circuit breaker (1), and a neutral conductor path (5) extending from a neutral conductor terminal (6) of the low-voltage circuit breaker (1) to a neutral conductor path terminal (7) of the low-voltage circuit breaker (1), wherein in the outer conductor path (2) a mechanical bypass switch (8) and a first mechanical breaker (9) are arranged in series, wherein in the neutral conductor path (5) a second mechanical breaker (10) is arranged, wherein a first semiconductor circuit arrangement (11) of the low-voltage circuit breaker (1) is connected in parallel to the bypass switch (8), wherein an electronic control unit (13) of the low-voltage circuit breaker (1) is designed to activate the bypass switch (8), the first mechanical breaker (9), the second mechanical breaker (10) and the first semiconductor circuit arrangement (11) in a predefinable manner, wherein the first semiconductor circuit arrangement (11) has a snubber (24) comprising a first capacitor (30), **characterised in that** the first capacitor (30) is designed as an energy store for activating the first breaker (9) and the second breaker (10), and **in that** the first capacitor (30) is connected by circuitry to a first actuator (31) of the first breaker (9) and the second breaker (10).

2. Low-voltage circuit breaker (1) according to claim 1, **characterised in that** the low-voltage circuit breaker (1) has a charging circuit (32) configured to charge the first capacitor (30) in a predefinable manner.

3. Low-voltage circuit breaker (1) according to claim 2, **characterised in that** the charging circuit (32) has a second semiconductor circuit arrangement (33) that is activated by the control unit (13).

4. Low-voltage circuit breaker (1) according to claim 3, **characterised in that** the second semiconductor circuit arrangement (33) is designed as a bidirectional four-quadrant switch.

5. Low-voltage circuit breaker (1) according to claim 3 or 4, **characterised in that** the charging circuit (32), in an interconnected state of the second semiconductor circuit arrangement (33) and when the bypass switch (8) is open, connects the first semiconductor circuit arrangement (11) to the outer conductor path (2) and the neutral conductor path (5).

6. Low-voltage circuit breaker (1) according to any of claims 1 to 5, **characterised in that** a third semiconductor circuit arrangement (34) is arranged in the first semiconductor circuit arrangement (11) in series with the snubber (24).

7. Low-voltage circuit breaker (1) according to any of claims 1 to 6, **characterised in that** the snubber (24) has a first resistor (35) which is disposed parallel to the first capacitor (30), and **in that** a discharge switch (36) is arranged in series with the first resistor (35) and in parallel to the first capacitor (30).

8. Low-voltage circuit breaker (1) according to claim 6 or 7, **characterised in that** upon activating the low-voltage circuit breaker (1), the electronic control unit (13) is configured firstly to activate the second semiconductor circuit arrangement (33), then to activate the third semiconductor circuit arrangement (34), then after reaching a predefinable charge of the first capacitor (30) firstly to close the second breaker (10) and subsequently the first breaker (9), then after reaching a stable state of the first breaker (9) and the second breaker (10) to activate the first semiconductor circuit arrangement (11) and then to close the bypass switch (8) and deactivate the first semiconductor circuit arrangement (11).

9. Low-voltage circuit breaker (1) according to any of claims 6 to 8, **characterised in that** the electronic control unit (13) is configured, when the low-voltage circuit breaker (1) is activated, to charge in a predefinable manner the first capacitor (30) by activating in a predefinable manner the second semiconductor circuit arrangement (33) and the third semiconductor circuit arrangement (34).

## Revendications

1. Disjoncteur basse tension (1) avec au moins une ligne de conducteur extérieur (2) d'une borne d'alimentation de conducteur extérieur (3) du disjoncteur basse tension (1) à une borne de charge de conducteur extérieur (4) du disjoncteur basse tension (1), et une ligne de conducteur neutre (5) d'une borne de conducteur neutre (6) du disjoncteur basse tension (1) à une borne de charge du conducteur neutre (7) du disjoncteur basse tension (1), dans lequel un commutateur de dérivation mécanique (8) et un premier sectionneur mécanique (9) sont montés en série dans la ligne de conducteur extérieur (2), dans lequel un deuxième sectionneur mécanique (10) est disposé dans la ligne de conducteur neutre (5), dans lequel un premier circuit semiconducteur (11) du disjoncteur basse tension (1) est monté en parallèle avec le commutateur de dérivation (8), dans lequel une unité de commande électronique (13) dudit disjoncteur basse tension (1) est conçue pour faire fonctionner de manière prédéterminable le commutateur de dérivation (8), le premier disjoncteur mécanique (9), le deuxième sectionneur mécanique (10) et le premier circuit semiconducteur (11), dans lequel le premier circuit semiconducteur (11) présente un amortisseur (24) comprenant un premier condensateur (30), **caractérisé en ce que** le premier condensateur (30) est conçu comme accumulateur d'énergie pour actionner le premier sectionneur (9) et le deuxième sectionneur (10), et **en ce que** le premier condensateur (30) est connecté à un premier dispositif d'actionnement (31) du premier sectionneur (9) et du deuxième sectionneur (10).

2. Disjoncteur basse tension (1) selon la revendication 1, **caractérisé en ce que** le disjoncteur basse tension (1) présente un circuit de charge (32) pour charger de manière prédéterminable le premier condensateur (30).

3. Disjoncteur basse tension (1) selon la revendication 2, **caractérisé en ce que** le circuit de charge (32) présente un deuxième circuit semiconducteur (33) commandé par l'unité de commande (13).

4. Disjoncteur basse tension (1) selon la revendication 3, **caractérisé en ce que** le deuxième circuit semiconducteur (33) est conçu comme commutateur bidirectionnel à quatre quadrants.

5. Disjoncteur basse tension (1) selon la revendication 3 ou 4, **caractérisé en ce que** le circuit de charge (32) connecte le premier circuit de charge (11) à la ligne de conducteur extérieur (2) et à la ligne de conducteur neutre (5) à l'état connecté du deuxième circuit semiconducteur (33) et lorsque le commutateur de dérivation (8) est ouvert.

6. Disjoncteur basse tension (1) selon l'une quelconque des revendications 1 à 5, **caractérisé en ce qu'**un troisième circuit semiconducteur (34) est monté dans le premier circuit semiconducteur (11) en série avec l'amortisseur (24).

7. Disjoncteur basse tension (1) selon l'une quelconque des revendications 1 à 6, **caractérisé en ce que** l'amortisseur (24) présente une première résistance (35) montée en parallèle avec le premier condensateur (30), et **en ce qu'**un interrupteur de décharge (36) est monté en série avec la première résistance (35) ainsi qu'en parallèle avec le premier condensateur (30).

8. Disjoncteur basse tension (1) selon la revendication 6 ou 7, **caractérisé en ce que** l'unité de commande électronique (13) est conçue, lorsque le disjoncteur basse tension (1) est mis en marche, pour mettre en marche d'abord le deuxième circuit semiconducteur (33) et ensuite le troisième circuit semiconducteur (34), puis, après avoir atteint une charge prédéterminable du premier condensateur (30), pour fermer d'abord le deuxième sectionneur (10), puis le premier sectionneur (9), puis, après avoir atteint un état stable du premier sectionneur (9) et du deuxième sectionneur (10), pour mettre en marche le premier circuit semiconducteur (11), puis pour fermer le commutateur de dérivation (8) et pour arrêter le premier circuit semiconducteur (11).

9. Disjoncteur basse tension (1) selon l'une quelconque des revendications 6 à 8, **caractérisé en ce que** l'unité de commande électronique (13) est conçue pour charger le premier condensateur (30) par un actionnement prédéterminable du deuxième circuit semiconducteur (33) et du troisième circuit semiconducteur (34) lorsque le disjoncteur basse tension (1) est mis en marche.
